# EUROPEAN PATENT APPLICATION

(11) **EP 2 262 004 A1**
(43) Date of publication of application: **15.12.2010**
(21) Application number: 09162501.2
(22) Date of filing: 11.06.2009
(51) Int. Cl.: H01L 31/052, H01L 31/058

(54) **Photovoltaic plant for production of electric energy**

(71) Applicant: Anaf Europe S.A., 3895 Foetz (LU)
(72) Inventor: Anaf, Yves Clemente, 20145 Milano (IT)
(74) Representative: Bonvicini, Davide

(57) **Abstract**

A photovoltaic plant (10) comprises photovoltaic means (20) suitable for converting solar radiation into electrical energy and heat-exchanger means (30) connected to the photovoltaic means (20). The photovoltaic means (20) comprise a photovoltaic panel having a first surface (21) suitable for being exposed to the solar radiation and a second surface (22) which is remote from the first surface (21) and is connected to the heat-exchanger means (30). In particular, the heat-exchanger means (30) comprise a roll-bond heat-exchanger panel associated with the second surface (22) of the photovoltaic panel (20) and having a first, flat sheet (31) and a second sheet (32) which face one another, are joined together in respective first portions (36, 37), and are spaced apart in respective second portions (38, 39) to define a continuous duct for a thermal convector fluid (33). The first sheet (31) defines a flat heat-exchange surface (31a) which is associated with the second surface (22) of the photovoltaic panel (20) for at least 50% of the second surface (22) of the photovoltaic panel (20).

## Description

The present invention relates to a photovoltaic plant for producing electrical energy. Photovoltaic plants for generating electrical energy are known in the art and are widely used in the renewable energies field.

A typical photovoltaic plant comprises a plurality of photovoltaic panels each of which, when exposed to solar radiation, converts the solar radiation into electrical energy.

In particular, when a photovoltaic panel is exposed to solar radiation, it produces a low-voltage direct current.

In order to be able to introduce the electrical energy produced by photovoltaic panels into a power distribution network, a photovoltaic plant is typically provided with a static conversion system which converts the direct current generated by the photovoltaic panels to the voltage and alternating current values specified by the network. Voltage transformers are used to ensure galvanic separation between the direct-current section of the plant and the alternating-voltage network.

Each photovoltaic panel comprises one or more interconnected photovoltaic cells.

The photovoltaic cell represents the elemental solar-radiation collection device upon which every photovoltaic plant for producing electrical energy is based. A photovoltaic cell behaves as a diode with a large surface area which, when exposed to solar radiation, converts the solar radiation into electrical energy, in particular, electrical energy in direct-current form.

At the moment, the solar cells that are most widely used are produced by the processing of silicon and may be crystalline, polycrystalline or monocrystalline, or amorphous.

One of the most desirable aims in the field of photovoltaic plants for producing electrical energy is to increase their productivity.

As is known, the efficiency of a photovoltaic panel is typically between 6% and 18% and varies according to the material used and the working temperature.

In fact, it should be pointed out that the efficiency of a photovoltaic panel is given under standard irradiation conditions and at an operating temperature of 25°C.

On the other hand, it is known that a photovoltaic panel has an efficiency loss in the conversion of the solar radiation into electrical energy since only some of the incident solar radiation is transformed into electrical energy whilst the rest leads to an increase in the operating temperature of the photovoltaic panel which, depending on ambient conditions, may even reach more than 70-80°C.

The increase in the temperature of the photovoltaic panel leads to a reduction in the conversion efficiency of the individual photovoltaic cells and hence of the photovoltaic panel and of the photovoltaic plant itself.

Typically, a photovoltaic panel has a power temperature coefficient of between -0.4%/°C and -0.55%/C° for any variation of the temperature from the ideal temperature of 25°C. Consequently, at operating temperatures of between 50°C and 60°C, the energy efficiency of a photovoltaic panel decreases by a value of between 10% and 20%.

There is therefore a great need to cool a photovoltaic panel so as to reduce its operating temperature to the ideal operating values and to optimize its energy efficiency in the conversion of solar radiation.

Many cooling systems for photovoltaic panels have been proposed in the prior art.

An example of a photovoltaic plant with a system for cooling the photovoltaic panels is described in European patent application EP 1 873 843.

According to the above-mentioned prior art, the photovoltaic plant comprises a photovoltaic panel and a heat exchanger which is disposed beneath the photovoltaic panel to absorb the heat generated thereby.

The exchanger is separated from the photovoltaic panel by means of an adhesive layer of thermally conductive material formed with an acrylic base and filled with TiO₂, graphite, SiC and Al₂O₃ to improve thermal conductivity characteristics. The heat exchanger is constituted by metal tubes in which a heat-exchange fluid, for example water, optionally mixed with glycol, is caused to flow. The metal tubes are carried by a metal plate which is in contact with the adhesive layer of thermally conductive material.

According to a different embodiment, the exchanger is made of moulded polymer material which is rendered thermally conductive by means of graphite, carbon fibre, or titanium oxide. This solution may also provide for a metal plate in contact with the adhesive layer of thermally conductive material.

However, the cooling system described above has disadvantages. First of all, it should be pointed out that a duct formed by metal tubes occupies only a small portion of the surface of the metal plate, thus reducing the area that is useful for the exchange of heat with the photovoltaic panel.

Moreover, it is stressed that the area of contact between the metal tube and the metal plate is reduced to 50% of the useful area of the tube and the tube-plate contact is unreliable and of poor quality from the heat-exchange point of view. In fact, it should be remembered that even a space of one tenth of a millimetre between tube and plate may lead to a 50% loss in thermal exchange efficiency.

It is also clear that the configuration of the duct is necessarily limited by the pitch of the metal tubes and by the size of the connections.

Furthermore, it is pointed out that the use of metal tubes and a metal plate has a considerable effect on the overall cost of the photovoltaic panel. When polymer tubes filled with graphite, carbon fibre or titanium oxide are used, the economic impact on the overall cost of the plant is even clearer and more significant.

Finally, it can be pointed out that the various steps of the assembly of the metal tubes and of the metal plate on a photovoltaic panel are lengthy and laborious.

From the foregoing, a need arises to provide a photovoltaic plant for producing electrical energy which enables the photovoltaic panels to be cooled effectively whilst keeping the costs of the cooling system low.

The object of the present invention is therefore to provide a photovoltaic plant for producing electrical energy that has structural and functional characteristics such as to satisfy the above-mentioned needs and at the same time to overcome the disadvantages discussed with reference to the prior art.

This object is achieved by a photovoltaic plant for producing electrical energy which comprises photovoltaic means suitable for converting solar radiation into electrical energy and heat-exchanger means connected to the photovoltaic means. The photovoltaic means comprise a photovoltaic panel having a first surface suitable for being exposed to the solar radiation and a second surface which is remote from the first surface and is connected to the heat-exchanger means. In particular, the heat-exchanger means comprise a roll-bond heat-exchanger panel associated with the second surface of the photovoltaic panel and having a first, flat sheet and a second sheet which face one another, are joined together in respective first portions, and are spaced apart in respective second portions to define a continuous duct for a thermal convector fluid.

In particular, the first sheet defines a flat heat-exchange surface which is associated with the second surface of the photovoltaic panel over at least 50% of the second surface of the photovoltaic panel.

This enables a highly efficient exchange of heat to be achieved and brings the photovoltaic panel substantially to the temperature of the fluid circulating in the duct of the heat-exchanger panel.

Further characteristics and the advantages of the photovoltaic plant for producing electrical energy according to the present invention will become clear from the following description of a preferred embodiment which is given by way of non-limiting example with reference to the appended drawings in which:
Figure 1 is a front view of a photovoltaic plant according to the present invention,

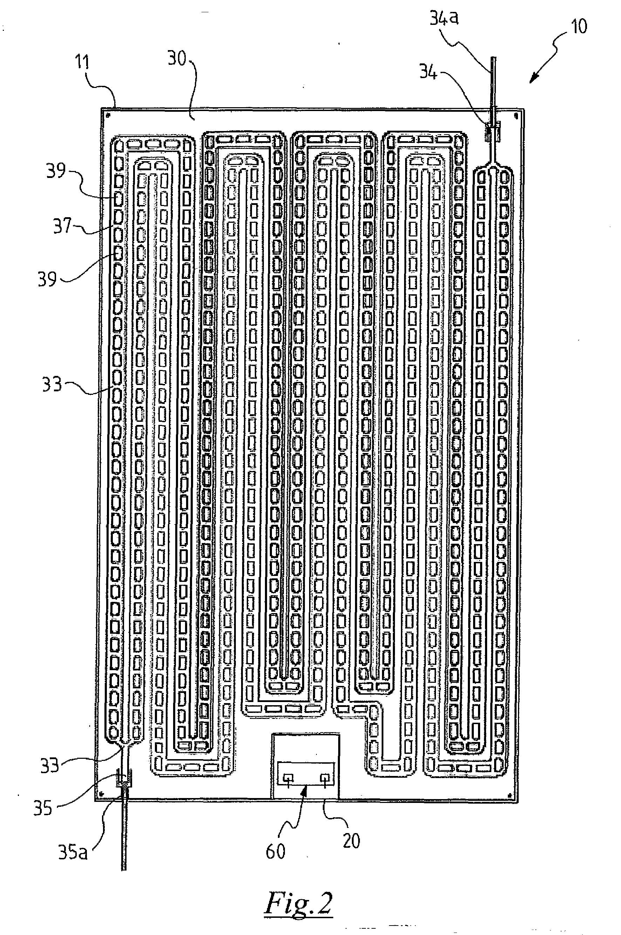

Figure 2 is a rear view of the plant of Figure 1, and
Figure 3 is a section taken on the section line III-III through the photovoltaic panel of the plant of Figure 1.

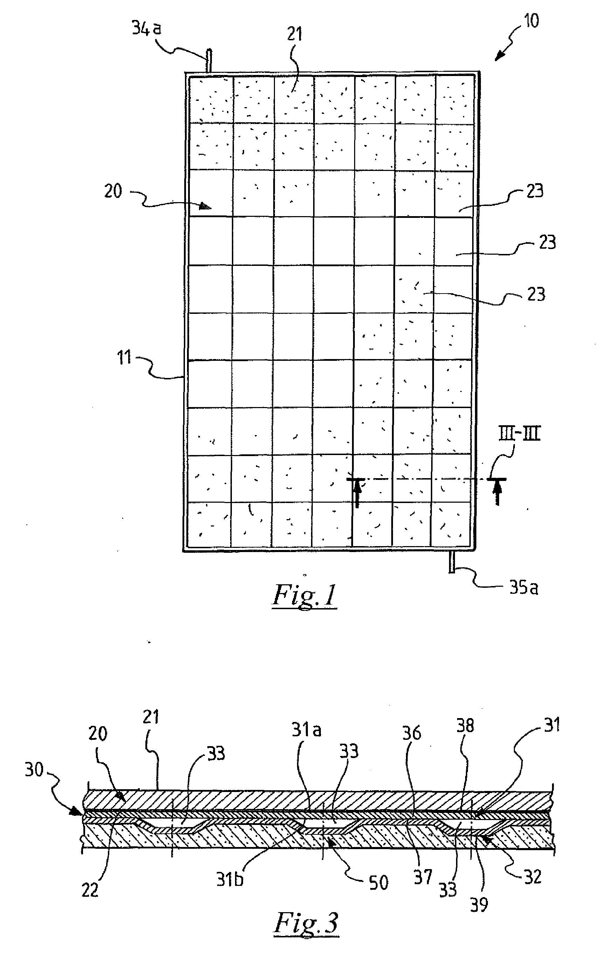

With reference to Figure 1, a photovoltaic plant for producing electrical energy is generally indicated 10.

The photovoltaic plant 10 comprises photovoltaic means 20 suitable for receiving solar radiation and converting the solar radiation into electrical energy, a support structure 11 for supporting the photovoltaic means 20, and heat-exchanger means 30 which are coupled to the photovoltaic means 20 in order to perform an exchange of heat with the photovoltaic means 20.

The support structure 11 can be installed on surfaces suitable for maximizing the collection of solar radiation such as roofs of dwellings or industrial complexes, terraces, or land used for the purpose.

The photovoltaic means 20 comprise a photovoltaic panel.

The photovoltaic panel 20 has a first surface 21 suitable for being exposed to solar radiation and a second surface 22 which is opposite to the first surface 21 and is associated with the heat-exchanger means 30.

With reference to the appended drawings, the first surface 21 and the second surface 22 correspond to the upper surface and the lower surface of the photovoltaic panel 20, respectively.

According to one embodiment, the photovoltaic panel 20 comprises a plurality of interconnected solar cells, indicated 23. Each solar cell 23, when exposed to solar radiation, converts the solar radiation into electrical energy, in particular electrical energy in direct-current form.

The solar cells may be crystalline, polycrystalline or monocrystalline, or amorphous.

In known manner, the photovoltaic panel 20 also comprises a pane of solar glass disposed on top of the photovoltaic cells, an ethyl-vinyl-acetate (EVA) layer disposed between the solar glass and the photovoltaic cells, and an EVA layer disposed between the photovoltaic cells and disposed beneath the photovoltaic cells. The solar glass and the EVA layers are not shown in the drawings and are not described further in the following description since they are known in the art.

The photovoltaic panel 20 further comprises electrical connection means 60 for connection to an electrical system. For example, the electrical connection means 60 may comprise a pair of cables provided with respective electrical connectors.

The heat-exchanger means 30 are suitable for absorbing the heat which the photovoltaic panel 20 produces as a result of exposure to solar radiation. In fact it should be pointed out that some of the solar radiation is transformed into electrical energy whilst some is converted into heat that can be dissipated to reduce the working temperature of the photovoltaic panel 20 and consequently improve its energy performance.

In particular, in order to effectively transfer the heat produced by the photovoltaic panel 20 to the heat-exchanger means 30, the heat-exchanger means 30 comprise a roll-bond heat-exchanger panel associated with the second surface 22 of the photovoltaic panel 20.

The roll-bond heat-exchanger panel 30 comprises a first, flat sheet 31 and a second sheet 32 which face one another, are joined together in respective first portions 36 and 37, and are spaced apart in respective second portions 38, 39, defining a duct 33 in which a thermal convector fluid, for example water, can flow.

The roll-bond heat-exchanger panel 30 further comprises a fluid-inlet opening 34 and a fluid-outlet opening 35 both of which are in flow communication with the duct 33.

In order to connect the roll-bond heat-exchanger panel 30 to a fluid-supply circuit, respective fluid-inlet connections 34a and fluid-outlet connections 35a are provided in the region of the fluid-inlet openings 34 and the fluid-outlet openings 35, respectively.

The fluid-inlet connection 34a is connected to a fluid-supply source, for example, the water mains.

The fluid-outlet connection 35a may be connected to a recovery tank or to the water mains. The fluid that is admitted at the inlet connection 34a may contain glycol to prevent the formation of ice. In this case, a closed-circuit fluid-supply system is provided, in which the fluid discharged from the roll-bond heat-exchanger panel 30 is cooled by means of heat exchangers or evaporation towers.

According to one embodiment, the roll-bond heat-exchanger panel 30 is a quadrangular panel having two diagonals and the fluid-inlet opening 34 and the fluid-outlet opening 35 are positioned at the opposite ends of one of the two diagonals so as to improve the flow of fluid circulating in the duct 33 from the fluid-inlet opening 34 to the fluid-outlet opening 35.

The first sheet 31 defines a flat heat-exchange surface 31a which is associated with the second surface 22 of the photovoltaic panel 20 over at least 50% of the second surface 22 of the photovoltaic panel 20.

According to one embodiment, the flat heat-exchange surface 31a is associated with the second surface 22 of the photovoltaic panel 20 over at least 75% of the second surface 22. According to one embodiment, the flat heat-exchange surface 31a is associated with the second surface 22 of the photovoltaic panel 20 over at least 90% of the second surface 22. According to one embodiment, the flat heat exchange surface 31a is associated with the second surface 22 of the photovoltaic panel 20 over the entire second surface 22 of the photovoltaic panel 20.

In particular, the first sheet 31 has an inner surface 31b facing towards the second sheet 32 and an outer surface 31a which defines the flat heat-exchange surface.

In the example shown in the appended drawings, the outer surface 31a represents the upper surface of the roll-bond panel 30 and extends over substantially the entire second surface 22 of the photovoltaic panel 20 except in the region of the electrical connection means 60 of the photovoltaic panel 20 where the roll-bond heat-exchanger 30 has an opening.

The roll-bond heat-exchanger panel 30 therefore has an effective heat-exchange surface, represented by the outer surface 31a of the sheet 31, which substantially corresponds to the lower surface 22 of the photovoltaic panel 20.

The second sheet 32 has an inner surface 32b facing towards the first sheet 31 and an outer surface 32a. In the example shown in the appended drawings, the outer surface 32b represents the lower surface of the roll-bond panel 30.

In particular, the inner surfaces 31b, 32b of the two sheets 31, 32 are welded together in the respective first portions 36, 37 and are spaced apart in the respective second portions 38, 39 so as to define the duct 33 for the flow of fluid.

According to one embodiment, the second sheet 32 projects, in the second portions 39, from the plane defined by the inner surface 31b of the first sheet 31, to define the duct 33.

It is worth pointing out that, owing to the roll-bond structure of the heat-exchanger panel 30, its surface temperature is uniform and substantially corresponds to the temperature of the fluid which is caused to circulate in the duct 33. The heat-exchanger panel 30 thus enables the thermal exchange to be distributed uniformly over the entire upper surface 31a of the first sheet 31. This aspect, together with the fact that the first sheet 31 defines a flat heat-exchange surface 31a that is associated with the second surface 22 of the photovoltaic panel 20 over at least 50% of that second surface, enables an extremely efficient exchange of heat with the photovoltaic panel 20 to be achieved and enables the working temperature of the photovoltaic panel 20 to be brought substantially to the temperature of the fluid circulating in the duct 33 of the heat-exchanger panel 30.

It is worth pointing out that the reduction in the working temperature of the photovoltaic panel 20 due to the high degree of thermal exchange which is established between the photovoltaic panel 20 and the heat-exchanger panel 30 leads to a reduction in the time taken for the photovoltaic cells and the EVA layer of the photovoltaic panel 20 to deteriorate and hence to a lengthening of the life cycle of the photovoltaic plant 10. According to one embodiment, the roll-bond heat-exchanger panel 30 is made of aluminium alloy.

The heat-exchanger panel 30 is produced by the roll-bond process. According to this process, a detachment element is applied to the inner surface of one of the two sheets 31, 32, for example to the inner surface 31a of the sheet 31. The detachment element may be, for example, an ink applied by serigraphy. In particular, the detachment element is applied to the sheet 31 along a path which represents the layout of the duct 33 to be produced.

The two sheets 31, 32 are then fitted together and hot-rolled so as to weld them in the portions 36, 37 of the inner surfaces 31a, 32a that are not covered by the detachment element. A fluid is then blown under pressure into the interior of the two sheets 31, 32 so as to bring about their detachment along the path defined by the detachment element and the formation of the duct 33. The two sheets 31, 32 are thus joined together solely in the portions 36, 37 in which the duct 33 is not present, that is, in the region of the inner surfaces to which the detachment element was not applied during the assembly stage. Finally, the fluid-inlet and fluid-outlet openings 34 and 35 and the respective connections 34a, 35a are formed.

According to one embodiment, adhesive means 40 made of thermally conductive material are interposed between the lower surface 22 of the photovoltaic panel 20 and the upper surface 31a of the roll-bond heat-exchanger panel 30 to keep the photovoltaic panel 20 joined together with the roll-bond heat-exchanger panel 30 and ensure thermal exchange between them. For example, the adhesive means 40 may be a double-sided adhesive layer or a layer of glue with good thermal conductivity.

In this case, the upper surface 31a of the roll-bond heat-exchanger panel 30 is in contact with the adhesive means 40 and is thereby associated with the lower surface 22 of the photovoltaic panel 20.

According to an alternative embodiment, the upper surface 31a of the heat-exchanger panel 30 may be placed directly in contact with the lower surface 22 of the photovoltaic panel 20.

The plant 10 according to the present invention has been tested with the use of two photovoltaic panels 20 model CEEG SST240-60M with peak power of 240 W, dimensions of 1640 x 990 and individual panel efficiency of 14.78%.

A roll-bond heat-exchanger panel 30 with dimensions of 1450 x 890 and having a flat heat-exchange surface 31a associated with the second surface 22 of the photovoltaic panel 20 over at least 79% of the second surface 22 was fitted on one of the two panels.

The roll-bond heat-exchanger panel 30 was glued to the lower surface 22 of the photovoltaic panel 20 by means of a thermally conductive double-sided adhesive 40. Respective temperature sensors were positioned on the fluid-inlet connection 34a and on the fluid-outlet connection 35a of the heat-exchanger panel 30 to monitor the temperature of the water admitted to and discharged from the heat-exchanger panel 30.

A flow-rate sensor was also put in place to measure the flow-rate of water admitted to the heat-exchanger panel 30.

The results of the measurements taken at different times of day are given below.

### Measurement 1

Ambient temperature: 28°C
Power of the photovoltaic panel without roll-bond: 140 Watts
Power of the photovoltaic panel with roll-bond: 154 Watts Flow-rate of water: 2.9 litres/minute
Water inlet temperature: 20.1°C
Water outlet temperature: 22.5°c
Increase in percentage of energy efficiency of the panel with roll-bond in comparison with the panel without roll-bond: 10%

### Measurement 2

Ambient temperature: 30°C
Power of the photovoltaic panel without roll-bond: 155 Watts
Power of the photovoltaic panel with roll-bond panel: 194 Watts
Flow-rate of water: 5.2 litres/minute
Water inlet temperature: 20.2°C
Water outlet temperature: 23.1°C
Increase in percentage of energy efficiency of the panel with roll-bond in comparison with the panel without roll-bond: 25%

### Measurement 3

Ambient temperature: 31°C
Power of the photovoltaic panel without roll-bond: 153 Watts
Power of the photovoltaic panel with roll-bond panel: 196 Watts
Flow-rate of water: 5.1 litres/minute
Water inlet temperature: 20.1°C
Water outlet temperature: 23.3°C
Increase in percentage of energy efficiency of the panel with roll-bond in comparison with the panel without roll-bond: 28%

### Measurement 4

Ambient temperature: 31°C
Power of the photovoltaic panel without roll-bond: 140 Watts
Power of the photovoltaic panel with roll-bond panel: 161 Watts
Flow-rate of water: 3.4 litres/minute
Water inlet temperature: 20.1°C
Water outlet temperature: 23.3°C
Increase in percentage of energy efficiency of the panel with roll-bond in comparison with the panel without roll-bond: 15%

The tests performed thus demonstrated a surprising increase in energy efficiency due to the lower working temperature of the photovoltaic panel 20.

It will be clear to a person skilled in the art that the percentage increase in energy efficiency may be increased further with the use of a roll-bond heat-exchanger panel 30 with a flat heat-exchange surface 31a that is associated with the second surface 22 of the photovoltaic panel 20 over substantially the entire second surface 22 and hence with dimensions corresponding to or close to the dimensions of the photovoltaic panel 20 so as to achieve an exchange of heat with all of the cells of the photovoltaic panel 20.

It should be pointed out that the plant 10 can also be used in winter to melt any snow or ice formed on the upper surface 21 of the photovoltaic panel 20. In fact, heated water can be admitted to and circulated in the ducts 33 of the photovoltaic panel 20 and the high heat-exchange coefficient of the roll-bond heat-exchanger panel 30 utilized to heat the photovoltaic panel 20, melt any snow and/or ice formed on its surface and thus reduce the time taken to re-establish the functional capacity of the photovoltaic panel.

In order further to increase the heat-exchange efficiency of the roll-bond heat-exchanger panel 30 with the photovoltaic panel 20, insulation means 50 may be associated with the roll-bond heat-exchanger panel 30.

For example, the insulation means 50 may comprise a polystyrene element or a foam of insulating material which encloses the heat-exchanger panel 30 at the bottom and at the sides.

As will be appreciated from the foregoing description, the photovoltaic plant according to the present invention overcomes the disadvantages mentioned with reference to the prior art.

By virtue of the large heat-exchange surface that is made available by the roll-bond heat-exchanger panel, its application to the photovoltaic panel enables the photovoltaic panel to be kept at a temperature substantially equal to the temperature of the fluid which is circulated inside the heat-exchanger panel. This enables the working temperature of the photovoltaic panel to be reduced and thus increases its energy efficiency as well as its life cycle.

Naturally, in order to satisfy contingent and specific requirements, a person skilled in the art will be able to apply to the above-described plant according to the invention many modifications and variations all of which, however, are included within the scope of protection of the invention as defined by the appended claims.

## Claims

1. A photovoltaic plant (10) comprising:
- photovoltaic means (20) suitable for receiving solar radiation and converting said solar radiation into electrical energy,
- heat-exchanger means (30) coupled to said photovoltaic means (20) for performing an exchange of heat with said photovoltaic means (20),
wherein
said photovoltaic means (20) comprise a photovoltaic panel having a first surface (21) suitable for being exposed to said solar radiation and a second surface (22) which is opposite to said first surface (21) and is coupled to said heat-exchanger means (30), **characterized in that**
- said heat-exchanger means (30) comprise a roll-bond heat-exchanger panel associated with said second surface (22) of the photovoltaic panel (20),
- said heat-exchanger panel (30) comprises a first, flat sheet (31) and a second sheet (32) which face one another, are joined together in respective first portions (36, 37), and are spaced apart in respective second portions (38, 39) to define a continuous duct for a thermal convector fluid (33), and
- said first sheet (31) defines a flat heat-exchange surface (31a) associated with said second surface (22) of the photovoltaic panel (20) over at least 50% of said second surface (22) of the photovoltaic panel (20).

2. A photovoltaic plant (1) according to Claim 1, wherein said flat heat-exchange surface (31a) is associated with said second surface (22) of the photovoltaic panel (20) over at least 75% of said second surface (22) of the photovoltaic panel (20).

3. A photovoltaic plant (1) according to Claim 1, wherein said flat heat-exchange surface (31a) is associated with said second surface (22) of the photovoltaic panel (20) for substantially the entire second surface (22) of the photovoltaic panel (20).

4. A photovoltaic plant (1) according to any one of Claims 1 to 3, wherein adhesive means (40) are interposed between the second surface (22) of the photovoltaic panel (20) and said flat heat-exchange surface (31a) of the first sheet (31) of the roll-bond heat-exchanger panel (30) for keeping the photovoltaic panel (20) joined together with the roll-bond heat-exchanger panel (30).

5. A photovoltaic plant (1) according to any one of Claims 1 to 3, wherein said flat heat-exchange surface (31a) of the first sheet (31) is directly in contact with said second surface (22) of the photovoltaic panel (20).

6. A photovoltaic plant (1) according to any one of Claims 1 to 5, wherein:
- said first sheet (31) has an inner surface (31b) facing towards said second sheet (32) and an outer surface (31a) defining said flat heat-exchange surface,
- said second sheet (32) has an inner surface (32b) facing towards said first sheet (31) and an outer surface (32a),
- said inner surfaces (31b, 32b) of said sheets (31, 32) are welded together in the respective first portions (36, 37) and are spaced apart in the respective second portions (38, 39) so as to define said duct (33).

7. A photovoltaic plant (1) according to Claim 6, wherein said second sheet (32) projects, in the respective second portions (39), from the plane defined by the first sheet (31) to define said duct (33).

8. A photovoltaic plant (1) according to any one of Claims 1 to 7, comprising insulation means (50) associated with the roll-bond heat-exchanger panel (30) to enclose and insulate said heat-exchanger panel (30).
